Europäisches Patentamt

European Patent Office

Office européen des brevets

(11) Veröffentlichungsnummer: **0 461 538 A1**

## (12) EUROPÄISCHE PATENTANMELDUNG

(21) Anmeldenummer: 91109166.8

(22) Anmeldetag: 05.06.91

(51) Int. Cl.5: **H03L 7/093**

(30) Priorität: 15.06.90 DE 4019154

(43) Veröffentlichungstag der Anmeldung:
18.12.91 Patentblatt 91/51

(84) Benannte Vertragsstaaten:
CH FR IT LI

(71) Anmelder: ANT Nachrichtentechnik GmbH
Gerberstrasse 33
W-7150 Backnang(DE)

(72) Erfinder: Alberty, Thomas, Dipl.-Ing.
Danziger Strasse 28
W-7150 Backnang(DE)
Erfinder: Widmann, Fritz, Dipl.-Ing.
Uhlandshöhe 34
W-7129 Ilsfeld(DE)

(54) **Hybrides Regelkreissystem.**

(57) Regelkreissystem, wobei die analoge Eingangsgröße mittels eines Analog-Digital-Konverters (ADC) digitalisiert und mittels eines Quantisierers (Q) quantisiert wird und wobei in einer Rückkoppelschleife die Regelgröße analog zurückgeführt wird, dadurch gekennzeichnet, daß für jeden momentanen quantisierten Digitalwert der Regelgröße der Quantisierungsfehler festgestellt, zwischengespeichert und zu dem nächsten unquantisierten Digitalwert addiert wird, daß jeweils die sich daraus ergebende Summe quantisiert wird und daß sich der Quantisierungsfehler jeweils aus der Differenz der Summe und ihres quantisierten Digitalwertes ergibt. Einsatz insbesondere in Richtfunksystemen zur Taktableitung von Übertragungssystemen mit hoher Übertragungsrate. Vorteil ergibt sich aus der Verhinderung des bei der Quantisierung üblicherweise erzeugten Taktphasenjitters.

Fig. 2

EP 0 461 538 A1

Die Erfindung bezieht sich auf ein hybrides Regelkreissystem gemäß Oberbegriff des Anspruches 1 bzw. 2.

Ein solches hybrides Regelkreissystem ist bekannt geworden durch den Aufsatz "Passband Timing Recovery in an All-Digital Modem Receiver" von Godard in IEEE 1978 Seite 517 und folgende. Eine Quantisierung ist dort allerdings nicht vorgesehen, ist aber im Zusammenhang mit Digital-Analog-Konvertern bekannt, beispielsweise durch das Buch "Digital Filters and Signal Processing" von Leland B. Jackson, Verlag Kluwer Academic Publishers, Boston, Massachusetts, USA, 2. Auflage von 1989 auf Seite 305 und folgende.

Regelkreise werden neuerdings immer häufiger digital realisiert, weil die Herstellungskosten im allgemeinen geringer sind als bei analoger Realisierung. Hinzu kommt der Vorteil der idealen Reproduzierbarkeit von digitalen Systemen, welche einen kostspieligen Einzelabgleich überflüssig macht.

Eine volldigitale Realisierung ist jedoch nicht in allen Fällen möglich; zum einen kann die Regelstrecke tatsächlich analog vorliegen, sodaß nur der Regler selbst digital ausgeführt werden kann, und zum anderen müssen Teile eines Regelsystems analog realisiert werden, wenn die erforderliche Abtastrate bei digitaler Realisierung zu hoch wäre.

Bei solchen hybriden Regelsystemen wird im allgemeinen ein Digital-Analog-Umsetzer benötigt, um den analogen Komponenten die gewünschten Ausgangssignale der digitalen Komponenten zuzuführen. Die Auflösungstiefe eines solchen Digital-Analog-Umsetzers hat natürlich einen Einfluß auf den Aufwand. Dies betrifft nicht nur den Umsetzer selbst, sondern auch den Digitalteil. Um einen Digital-Analog-Umsetzer mit der Auflösung von m-bit ansteuern zu können, muß der Digitalteil Signale mit derselben Wortbreite von m-bit liefern können. Dies hat Einfluß auf die Wahl der Größe des Gehäuses für den integrierten Schaltkreis des digitalen Teils. Andererseits darf die Auflösung des Digital-Analog-Umsetzers nicht beliebig grob, d.h. m nicht beliebig klein, sein, da die Reduzierung der internen Wortbreite n auf die Ausgangswortbreite m des Digitalteils (eine Reduzierung wird durch eine Quantisierung erreicht) zu sogenannten Quantisierungsfehlern führt. Diese Quantisierungsfehler beeinträchtigen die Leistungsfähigkeit eines Regelsystems unter Umständen beträchtlich.

Der vorliegenden Erfindung lag deshalb die Aufgabe zugrunde, ein hybrides Regelkreissystem der eingangsgenannten Art anzugeben, das trotz auftretender Quantisierungsfehler in aufwandsarmer Weise eine hohe Regelgüte liefert.

Die Lösung dieser Aufgabe erfolgte durch die gekennzeichneten Merkmale des Anspruches 1 bzw. 2.

Vorteilhafte Ausgestaltungen ergeben sich durch die Unteransprüche.

Das erfindungsgemäße hybride Regelkreissystem weist die Vorteile auf, daß die Quantisierungsfehler die Regelgüte kaum beeinträchtigen, d.h. daß die Quantisierungsfehler nicht mehr zu einer stark schwankenden Regelgröße (Jitter) führen. Dies wird erreicht durch kaum nennenswerten zusätzlichen Aufwand.

Ein solches hybrides Regelkreissystem läßt sich insbesondere bei der Taktableitung in Übertragungssystemen mit hoher Datenübertragungsrate, beispielsweise bei einem Richtfunksystem, einsetzen.

Es folgt nun die Beschreibung der Erfindung anhand der Figuren.

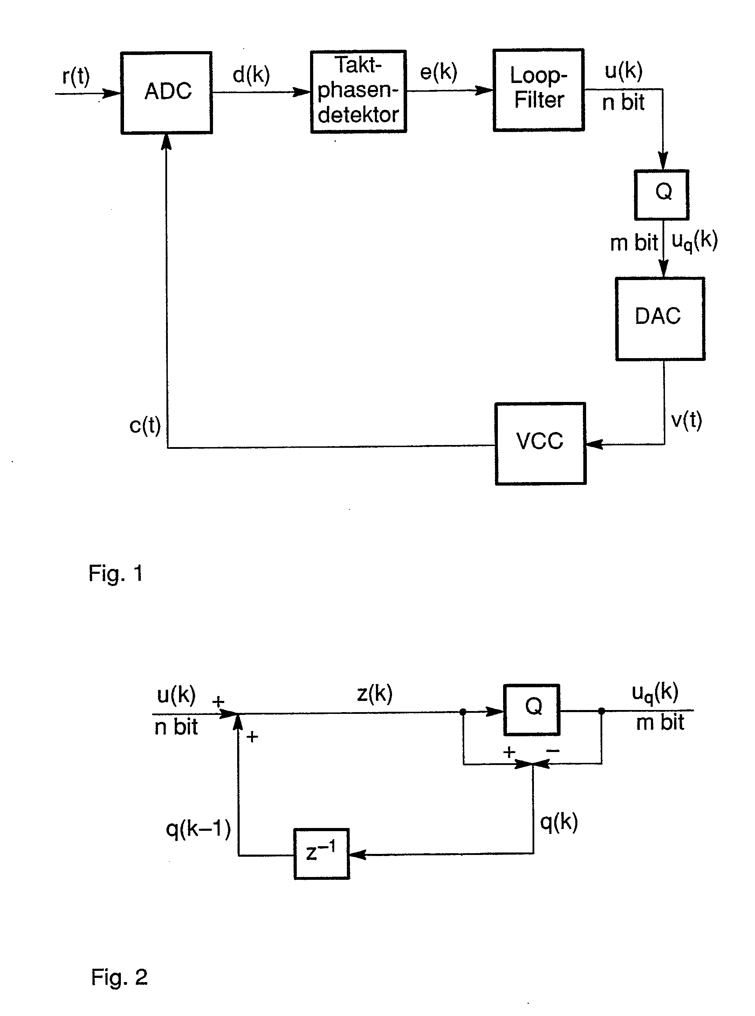

Die Figur 1 zeigt die allgemeine Struktur einer Taktableitungsschaltungsanordnung und die Figur 2 einen Teil davon mit der erfindungsgemäßen Verbesserung.

In Figur 1 ist das Blockschaltbild einer Taktableitungsschaltungsanordnung dargestellt. Das Empfangssignal $r(t)$ wird einem Analog-Digital-Umsetzer ADC zugeführt, welcher die Eingangssequenz $d(k)$ für den Digitalteil der hybriden Regelkreisanordnung erzeugt. Der nachfolgende Taktphasendetektor bestimmt daraus die Taktfehlersequenz $e(k)$, aus welcher mittels des Schleifenfilters (Loop-Filter) die Steuersequenz $u(k)$ mit einer Wortbreite von n-bit erzeugt wird. Mittels des nachfolgenden Quantisierers Q wird daraus eine Ausgangssequenz $u_q(k)$ mit einer Wortbreite von m-bit erzeugt. Der nachfolgende Digital-Analog-Konverter DAC erzeugt daraus die Steuerspannung $v(t)$ für den spannungsgesteuerten Takt-Oszillator VCC, der schließlich das Abtastsignal $c(t)$ für den eingangsseitigen Anlaog-Digital-Umsetzer ADC liefert.

Als Quantisierungsoperationen bieten sich an Runden, Abschneiden oder betragsmäßiges Abschneiden. Für die Erzeugung der gewünschten Taktphase des Abtasttaktes $c(t)$ wirkt der spannungsgesteuerte Oszillator VCC wie ein Integrator. Die erzeugte Taktphase ist daher proportional zur Summe der Ausgangssequenz $u_q(k)$ des Quantisierers Q. Damit wirkt sich auch eine Summe von Quantisierungsfehlern aus, was zu starkem Taktphasenjitter führt.

Die Erfindung ist nun der Figur 2 zu entnehmen, welche eine Korrekturschaltung zu der verwendeten Quantisierungsfunktion Q darstellt. Durch diese Korrekturschaltung wird erreicht, daß bei der Summierung der resultierenden Ausgangssequenz $u_q(k)$ eine Summe von Quantisierungsfehlern verhindert wird. Dies wird ermöglicht, daß zu dem k-ten Ausgangswert $u(k)$ des Schleifenfilters (Loop-Filter) der (k-1)-te Quantisierungsfehler $u_q(k-1)$ addiert wird. So erhält man eine neue Steuerfunktion $z(k)$, welche dem Quantisierer Q wiederum zugeführt wird. Dessen quantisiertes Ausgangssignal $u_q(k)$ wird nun dem Digital-Analog-Konverter DAC zugeführt. Als Quantisierungsfehler $q(k)$ wird jeweils die Differenz von Eingangs- und Ausgangssignal des Quantisierers Q bestimmt. Der Quantisierungsfehler wird einem Verzögerungselement $z^{-1}$ zugeführt zur Zwischenspeicherung bis zum nächsten Quantisierungstakt.

**Patentansprüche**

1. Hybrides Regelkreissystem mit einem analogen und einem digitalen Zweig, die durch einen Analog-Digital-Umsetzer und einen Digital-Analog-Umsetzer miteinander verbunden sind und wobei der Analog-Zweig in der Rückkoppelschleife einen Integrator für die Regelgröße aufweist und wobei der Digital-Zweig einen Quantisierer enthält, dadurch gekennzeichnet, daß jeweils für die einzelnen Digitalwerte der Regelgröße der Quantisierungsfehler festgestellt wird, daß dieser Quantisierungsfehler zwischengespeichert wird und jeweils vor der erneuten Quantisierung zum nächsten Digitalwert der Regelgröße addiert wird.

2. Hybrides Regelkreissystem, mit einem Analog- und einem Digitalzweig, wobei die analoge eingangsseitige Regelgröße mittels eines Analog-Digital-Umsetzers digitalisiert und anschließend mittels eines Quantisierers quantisiert wird und in einer Rückkoppelschleife mittels eines Digital-Analog-Umsetzers analogisiert und mittels eines Integrators auf den Abtasttakteingang des eingangsseitigen Analog-Digital-Umsetzers zurückgeführt wird, dadurch gekennzeichnet, daß für jeden momentanen quantisierten k-ten Digitalwert($u_q(k)$) der Regelgröße der Quantisierungsfehler ($q(k)$) festgestellt, zwischengespeichert und zu dem nächsten zeitlich folgenden (k + 1.)-ten unquantisierten Digitalwert ($u(k)$) addiert wird und daß jeweils die sich ergebende Summe ($z(k)$) quantisiert wird und daß sich jeweils der Quantisierungsfehler ($q(k)$) aus der Differenz dieser Summe ($z(k)$) und ihres quantisierten Digitalwertes ($u_q(k)$) ergibt.

3. Hybrides Regelkreissystem nach Anspruch 2, für Taktableitung, mit einem Taktphasendetektor und einem Tiefpaßfilter (Loop-Filter) im Digitalzweig, mit einem spannungsgesteuerten Oszillator (VCC) im Analogzweig, dadurch gekennzeichnet, daß als Zwischenspeicher ein Verzögerungsglied ($z^{-1}$) vorgesehen ist, welches mit jedem Arbeitstakt den momentan anstehenden k-ten digalen Quantisierungsfehlerwert ($q(k)$) einschreibt und den zeitlich vorangegangenen (k-1)ten Quantisierungsfehlerwert

($q(k-1)$) ausliest.

4. Hybrides Regelkreissystem nach Anspruch 3, dadurch gekennzeichnet, daß der Arbeitstakt von Quantisierer (Q) und Zwischenspeicher ($z^{-1}$) ein Vielfaches des Arbeitstaktes des Loop-Filters beträgt.

5. Hybrides Regelkreissystem nach Anspruch 4 oder 5, dadurch gekennzeichnet, daß die Rate des Abtastsignals ($c(t)$)des Analog-Digital-Umsetzers (ADC) ein Vielfaches der Rate des Arbeitstaktes des Loop-Filters ist.

Fig. 1

Fig. 2

Europäisches
Patentamt

**EUROPÄISCHER
RECHERCHENBERICHT**

Nummer der Anmeldung

**EP 91 10 9166**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 356 548   (SIEMENS AKTIENGESELLSCHAFT) <br> * Seite 2, Zeile 48 - Seite 4, Zeile 21; Abbildungen 1,2 * <br> — — — | 1-3,5 | H 03 L 7/093 |
| Y | PATENT ABSTRACTS OF JAPAN vol. 6, no. 55 (E-101)10. April 1982 <br> & JP-A-56 169 421 (TOSHIBA CORP. ) 26. Dezember 1981 <br> * das ganze Dokument * <br> — — — | 1-3 | |
| P,Y | EP-A-0 391 464   (PHILIPS PATENTVERWALTUNG GMBH) <br> * Spalte 2, Absatz 32 - Spalte 4, Zeile 49; Abbildung * <br> — — — — — | 1-3,5 | |
| | | | **RECHERCHIERTE SACHGEBIETE (Int. Cl.5)** |
| | | | H 03 L |

Der vorliegende Recherchenbericht wurde für alle Patentansprüche erstellt

| Recherchenort | Abschlußdatum der Recherche | Prüfer |
|---|---|---|
| Den Haag | 10 September 91 | BALBINOT H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

————————————————————————————
& : Mitglied der gleichen Patentfamilie, übereinstimmendes Dokument